# EUROPÄISCHE PATENTSCHRIFT

(11) **EP 2 557 907 B1**
(45) Veröffentlichungstag und Bekanntmachung des Hinweises auf die Patenterteilung: **18.12.2013**
(21) Anmeldenummer: 11177279.4
(22) Anmeldetag: 11.08.2011
(51) Int. Cl.: H05K 7/20

(54) **Kühlungsanordnung zum Kühlen eines Stromrichtermoduls**
Cooling assembly for cooling a frequency converter module
Agencement de refroidissement d'un module de convertisseur de courant

(43) Veröffentlichungstag der Anmeldung: 13.02.2013
(73) Patentinhaber: Siemens Aktiengesellschaft, 80333 München (DE)
(72) Erfinder: Schwesig, Günter, 91054 Erlangen (DE)

(56) Entgegenhaltungen:
- WO-A1-02/35898
- DE-A1-102007 023 058
- DE-A1-102008 001 028
- US-A- 5 745 343
- US-A- 5 914 860

## Beschreibung

Die Erfindung betrifft eine Kühlungsanordnung zum Kühlen eines Stromrichtermoduls, welche zur Verwendung bei einem Elektro- und/oder Hybridfahrzeug geeignet ist, gemäß dem Oberbegriff des Anspruchs 1. Eine derartige Kühlungsanordnung ist aus der DE 10 208 001 028 A1 bekannt.

Üblicherweise erzeugen gewisse Halbleitereinrichtungen im Betrieb übermäßige Wärme. Dies trifft besonders auf Leistungshalbleitereinrichtungen zu, welche üblicherweise als Schalter oder Gleichrichter bei elektrischen Hochleistungsschaltungen verwendet werden. Beispielsweise werden Wechselrichter bei Elektro- und Hybridelektrofahrzeugen eingesetzt, um den elektrischen Antriebsmotor des Fahrzeugs mit einer dreiphasigen Betriebsspannung zu versorgen. Wechselrichter und andere derartige Einrichtungen müssen typischerweise gekühlt werden, um eine korrekte Funktion sicherzustellen. Aus diesem Grund sind die Leistungsmodule, in welchen derartige Leistungseinrichtungen untergebracht sind, häufig mit einem Kühlungssystem ausgestattet.

Für Elektrofahrzeuge werden Wechselrichter und Antriebselektronik zudem in einem Gehäuse mit hoher Schutzart, in der Regel ≥ IP65 angeordnet. Die im Betrieb entstehende Verlustleistung, primär durch die Leistungselektronik, wird über'eine Flüssigkeitskühlung abgeführt. Dabei werden die Leistungshalbleiter mit Flüssigkeit umspült. Dennoch werden im Innenraum des Gehäuses teilweise derart hohe Temperaturen erreicht, dass die auf Leiterplatten angeordnete Antriebselektronik unerlaubt hohe Temperaturen annimmt.

Die Leiterplatten der Antriebselektronik werden z.B. zur Kühlung über sogenannte Gap-Pads, eine Wärmeleitfolie mit elektrisch isolierenden Eigenschaften und einem Betriebstemperaturbereich von ca. -60°C bis 200°C, an den Gehäusedeckel thermisch angebunden. Diese Maßnahme bedingt eine entsprechend niedrige Deckeltemperatur.

Es ist daher Aufgabe der Erfindung, eine Kühlungsanordnung, insbesondere zum Kühlen eines Stromrichtermoduls, mit verbesserter Kühlleistung anzugeben. Zudem soll die Kühlungsanordnung auf möglichst geringem Raum angeordnet werden können.

Diese Aufgabe wird erfindungsgemäß gelöst durch die Merkmale des Anspruchs 1. Vorteilhafte Ausgestaltungen und Weiterbildungen sind Gegenstand der Unteransprüche.

Hierzu weist die Kühlungsanordnung, insbesondere zum Kühlen eines Stromrichtermoduls der eingangs genannten Art, ein Stromrichterkomponenten aufnehmendes Gehäuse mit einem von einer Gehäusewandung umgebenen Gehäuseinnenraum auf. Ferner ist eine erste Kühlstruktur zur Flüssigkeitskühlung eines in dem Gehäuseinnenraum angeordneten Leistungshalbleitermoduls sowie eine zweite Kühlstruktur zur Flüssigkeitskühlung eines Gehäusedeckels des Gehäuses des Stromrichtermoduls vorgesehen. Dabei stehen die erste Kühlstruktur und die zweite Kühlstruktur miteinander in Verbindung.

Die erste Kühlstruktur weist einen Zulauf zur Zuleitung von Kühlflüssigkeit zum Leistungshalbleitermodul, eine Kühlwanne unterhalb des Leistungshalbleitermoduls und einen Rücklauf zur Ableitung von Kühlflüssigkeit von dem Leistungshalbleitermodul auf. Somit kann eine effektive Kühlung des Leistungshalbleitermoduls erfolgen.

Die zweite Kühlstruktur weist einen in der Gehäusewandung angeordneten ersten Bypasskanal zur Zuleitung von Kühlflüssigkeit zu dem Gehäusedeckel, den Gehäusedeckel selbst und einen in der Gehäusewandung angeordneten zweiten Bypasskanal zur Ableitung von Kühlflüssigkeit von dem Gehäusedeckel auf. Somit kann die Kühlstruktur auf geringem Raum angeordnet werden. Zudem ist die Kühlstruktur im Gegensatz zu einem Vorsehen der Rohre im Gehäuseinnenraum weniger der im Gehäuseinnenraum vorhandenen Wärmeentwicklung ausgesetzt.

Die Kombination der ersten und zweiten Kühlstruktur kann somit eine Verbesserung der Kühlleistung ermöglichen. Durch die Anordnung der zweiten Kühlstruktur in jeweiligen Gehäusewandungen und dem Gehäusedeckel des Stromrichtermoduls kann zudem die Unterbringung der Kühlanordnung auf geringem Raum erreicht werden.

Gemäß einer vorteilhaften Weiterbildung ist vorgesehen, dass der Gehäusedeckel aus einem Deckeloberteil und einem Deckelunterteil besteht und diese derart ausgeformt sind, dass der Gehäusedeckel in zusammengefügtem Zustand im Inneren einen Kühlkanal aufweist. Somit kann eine effektive Kühlung der am Gehäusedeckel thermisch angebunden und auf Leiterplatten angeordneten Antriebselektronik gewährleistet werden.

In zweckmäßiger Weise ist zudem vorgesehen, dass das Deckeloberteil eine Oberhälfte des Kühlkanals und das Deckelunterteil eine Unterhälfte des Kühlkanals aufweist. Hierdurch wird gegenüber einem einteilig ausgebildeten Gehäusedeckel der Vorteil erzielt, dass der Gehäusedeckel zur Ausbildung eines Kühlkanals z.B. nicht mit Bohrungen versehen werden muss bzw. nicht das Erfordernis besteht, im Inneren des Deckels einen Hohlraum vorzusehen, um einen Kühlkanal verlegen zu können.

Vorzugsweise sind das Deckeloberteil und das Deckelunterteil Druckgussteile. Dadurch kann der Kühlkanal je nach den Erfordernissen in beliebiger Form ausgebildet und eine optimale Nutzung des vorhandenen Raums erreicht werden.

In einer geeigneten Ausgestaltung ist das Gehäuse mit dem Gehäusedeckel verschraubt. Dadurch besteht eine einfache Zugänglichkeit der Umrichterkomponenten.

Zweckmäßiger Weise sind das Deckeloberteil und das Deckelunterteil miteinander verschraubt, verschweißt oder verklebt. Je nach verwendetem Material des Deckels kann somit eine optimale Befestigung des Deckelober- und Deckelunterteils vorgesehen werden.

Die Elektronik-Baugruppen sind vorzugsweise unterhalb des Gehäusedeckels angeordnet. Durch die integrale Ausbildung des Kühlkanals im Gehäusedeckel kann somit eine gleichmäßige Flächenkühlung des Gehäusedeckels bzw. Wärmeübertragung von den Elektronik-Komponenten auf die Kühlstruktur erfolgen.

In zweckmäßiger Weise können die erste Kühlstruktur und die zweite Kühlstruktur miteinander parallel oder in Serie verbunden sein. Eine Parallelverbindung der ersten und zweiten Kühlstruktur bedeutet eine uniforme Kühlung des Leistungshalbleitermoduls und der unterhalb des Gehäusedeckels angeordneten Elektronik-Komponenten. Eine Verbindung der ersten und zweiten Kühlstruktur in Serie hat je nach Anordnung eine stärkere Kühlung entweder des Leistungshalbleitermoduls oder der Elektronik-Komponenten zur Folge. Die Verbindung der Kühlstrukturen kann daher in optimaler Weise an die Erfordernisse bzw. die technische Auslegung des Systems angepasst werden.

Nachfolgend werden Ausführungsbeispiele der Erfindung anhand einer Zeichnung näher erläutert. Darin zeigen:
- FIG 1: in perspektivischer Ansicht eine schematische Darstellung eines Stromrichtermoduls mit einem Gehäuse bei geschlossenem Gehäusedeckel,
- FIG 2: in einer Darstellung gemäß FIG 1 das Stromrichtermodul bei abgenommenem Gehäusedeckel mit Blick in den Gehäuseinnenraum des Gehäuses auf eine Kühlungsanordnung,
- FIG 3: in perspektivischer Ansicht den Gehäusedeckel mit erfindungsgemäßer Kühlungsanordnung, und
- FIG 4: eine perspektivische Ansicht auf die Deckelunterseite des Gehäusedeckels.

Einander entsprechende Teile sind in allen Figuren mit den gleichen Bezugszeichen versehen.

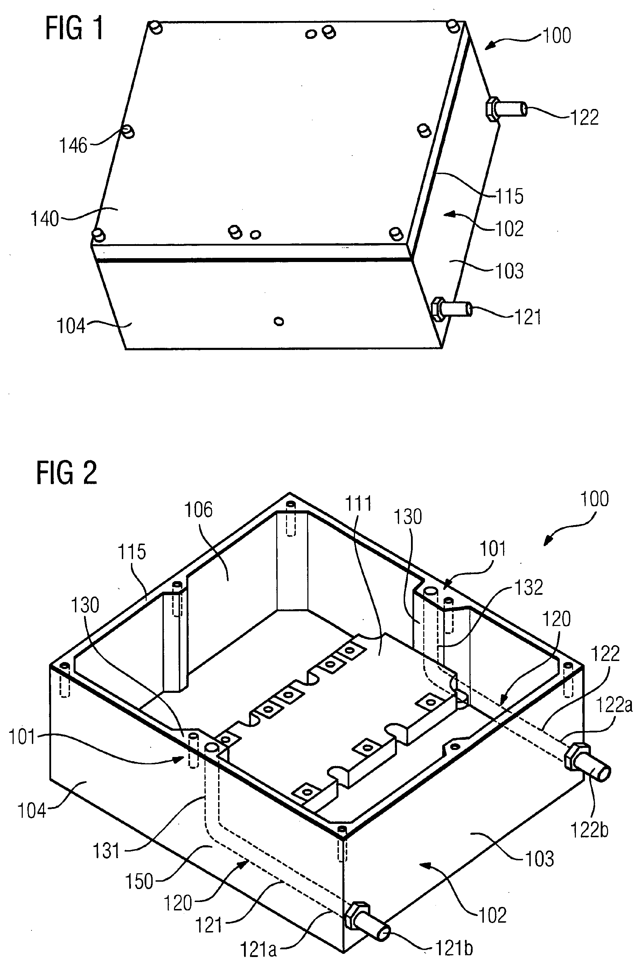

FIG 1 zeigt eine schematische Darstellung eines Stromrichtermoduls 100, das hermetisch abgedichtet ist und eine Kühlungsanordnung 101 (FIG 2) in einem Gehäuse 102 aufweist. Das Gehäuse 102 besteht aus einer Gehäusewandung 103 und einem Gehäusedeckel 140. Der Gehäusedeckel 140 ist auf ein von der Gehäusewandung 103 gebildetes Gehäuseunterteil 104, das einen Gehäuseinnenraum 106 umschließt, mittels einer Mehrzahl von Befestigungsschrauben 146 angebracht. Das Gehäuse 102 weist ferner einen Zulauf 121 zur Zuleitung von Kühlflüssigkeit zu einem Leistungshalbleitermodul und einen Rücklauf 122 zur Ableitung von Kühlflüssigkeit von dem Leistungshalbleitermodul auf. Zwischen dem Gehäuseunterteil 104 und dem Gehäusedeckel 140 ist zudem eine Dichtung 115 angeordnet.

FIG 2 zeigt das Gehäuse 102 mit Blick in den Gehäuseinnenraum 106 auf die Kühlungsanordnung 101. Eine erste Kühlstruktur 120 weist einen Zulauf 121 zur Zuleitung von Kühlflüssigkeit zum Leistungshalbleitermodul 111, eine Kühlwanne 150 unterhalb des Leistungshalbleitermoduls 111 und einen Rücklauf 122 zur Ableitung von Kühlflüssigkeit von dem Leistungshalbleitermodul 111 auf.

Der Zulauf 121 besteht aus einem gehäuseseitigen Anschluss 121b und einer im Gehäuseinnenraum 106 angeordneten Kühlleitung 121a, die sich vom Anschluss 121b bis zur Kühlwanne 150 erstreckt. Der Rücklauf 122 besteht aus einem gehäuseseitigen Anschluss 122b und einer im Gehäuseinnenraum 106 angeordneten Kühlleitung 122a, die sich von der Kühlwanne 150 bis zum Anschluss 122b erstreckt.

Kühlflüssigkeit wird durch den Zulauf 121 in die Kühlwanne 150 geleitet, welche unterhalb des Leistungshalbleitermoduls 111 angeordnet ist, sodass eine Bodenplatte bzw. Bodenplatten des Halbleitermoduls von Kühlflüssigkeit umspült wird. Über den Rücklauf 122 wird die Kühlflüssigkeit anschließend erneut abgeleitet und einem (nicht gezeigten) Motorkühler zugeführt.

Eine zweite Kühlstruktur 130 weist einen in der Gehäusewandung 103 angeordneten ersten Bypasskanal 131 zur Zuleitung von Kühlflüssigkeit zu dem Gehäusedeckel 140, den Gehäusedeckel selbst und einen in der Gehäusewandung 103 angeordneten zweiten Bypasskanal 132 zur Ableitung von Kühlflüssigkeit von dem Gehäusedeckel 140 auf.

Der erste Bypasskanal 131 erstreckt sich im vorliegenden Ausführungsbeispiel von einer Abzweigung des Kühlkanals 121a des Zulaufs 121 in einem Vorsprung bzw. einer Ausbuchtung der Gehäusewandung 103 im Gehäuseinnenraum 104 vertikal in Richtung des Gehäusedeckels 140. Der erste Bypasskanal 131 mündet an der Schnittstelle zwischen Gehäuseunterteil 104 und Gehäusedeckel 140 in den im Gehäusedeckel 140 angeordneten Kühlkanal. Der Kühlkanal erstreckt sich sodann durch den Gehäusedeckel 140 und mündet an der Schnittstelle zwischen Gehäusedeckel 140 und Gehäuseunterteil 104 in den zweiten Bypasskanal 132. Der zweite Bypasskanal 132 erstreckt sich in einem Vorsprung bzw. einer Ausbuchtung der Gehäusewandung 103 im Gehäuseinnenraum 106 vertikal in Richtung des Gehäusebodens bis zu einer Abzweigung des Kühlkanals 122a.

Kühlflüssigkeit wird durch den Zulauf 121 teilweise in die Kühlwanne 150 und teilweise in den Bypasskanal 131 geleitet, sodass sowohl das Leistungshalbleitermodul als auch der Gehäusedeckel 140 mit Kühlflüssigkeit versorgt werden und die Kühlflüssigkeit anschließend durch den Rücklauf 122 abgeleitet wird.

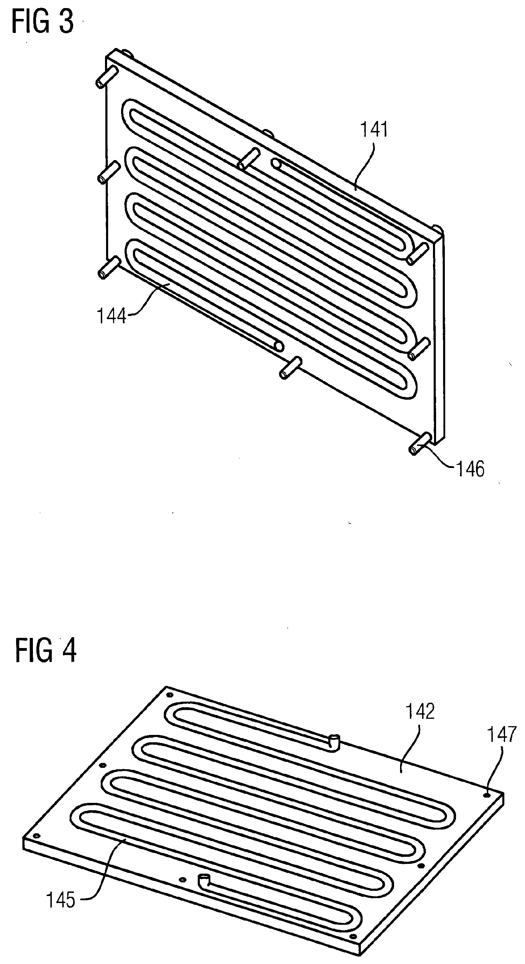

FIG 3 zeigt eine Deckeloberseite 141 des Gehäusedeckels 140 der Kühlungsanordnung. Die Deckeloberseite 141 weist eine Oberhälfte 144 des Kühlkanals auf. Zudem sind Befestigungsschrauben 146 zum Verbinden der Deckeloberseite 141 und der Deckelunterseite 141 vorgesehen. Die Befestigungsschrauben 146 werden, wie vorstehend beschrieben, auch zum Befestigen des Gehäusedeckels 140 an dem Gehäuseunterteil 104 genutzt.

FIG 4 zeigt die Deckelunterseite 142 des Gehäusedeckels 140 der Kühlungsanordnung. Die Deckelunterseite 142 weist eine Unterhälfte 145 des Kühlkanals auf. Zudem sind in der Deckelunterseite 142 eine Mehrzahl von Durchgangslöchern 147 zur Aufnahme der Befestigungsschrauben 146 vorgesehen. Die Durchgangslöcher 147 sind hierzu mit einem Innengewinde ausgebildet.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

## Patentansprüche

1. Kühlungsanordnung (101) zum Kühlen eines Stromrichtermoduls (100), mit einem Stromrichterkomponenten aufnehmenden Gehäuse (102) mit einem von einer Gehäusewandung (103) umgebenen Gehäuseinnenraum (106) und mit einer ersten Kühlstruktur (120) zur Flüssigkeitskühlung eines in dem Gehäuseinnenraum (106) angeordneten Leistungshalbleitermoduls (111) sowie mit einer zweiten Kühlstruktur (130) zur Flüssigkeitskühlung eines Gehäusedeckels (140) des Gehäuses (102) des Stromrichtermoduls (100), wobei die erste Kühlstruktur und die zweite Kühlstruktur miteinander in Verbindung stehen,
**dadurch gekennzeichnet,**
- **dass** die erste Kühlstruktur (120) einen Zulauf (121) zur Zuleitung von Kühlflüssigkeit zum Leistungshalbleitermodul (111) und eine Kühlwanne (150) unterhalb des Leistungshalbleitermoduls (111) sowie einen Rücklauf (122) zur Ableitung von Kühlflüssigkeit von dem Leistungshalbleitermodul (111) aufweist, und
- **dass** die zweite Kühlstruktur (130) einen in der Gehäusewandung (103) angeordneten ersten Bypasskanal (131) zur Zuleitung von Kühlflüssigkeit zu dem Gehäusedeckel (140) und den Gehäusedeckel selbst sowie einen in der Gehäusewandung (103) angeordneten zweiten Bypasskanal (132) zur Ableitung von Kühlflüssigkeit von dem Gehäusedeckel (140) aufweist.

2. Kühlungsanordnung nach Anspruch 1,
**dadurch gekennzeichnet, dass** der Gehäusedeckel (140) aus einem Deckeloberteil (141) und einem Deckelunterteil (142) besteht und diese derart ausgeformt sind, dass der Gehäusedeckel (140) in zusammengefügtem Zustand im Inneren einen Kühlkanal aufweist.

3. Kühlungsanordnung nach Anspruch 2,
**dadurch gekennzeichnet, dass** das Deckeloberteil (141) eine Oberhälfte (144) des Kühlkanals und das Deckelunterteil (142) eine Unterhälfte (145) des Kühlkanals aufweist.

4. Kühlungsanordnung nach Anspruch 2 oder 3,
**dadurch gekennzeichnet, dass** das Deckeloberteil (141) und das Deckelunterteil (142) Druckgussteile sind.

5. Kühlungsanordnung nach einem der Ansprüche 1 bis 4,
**dadurch gekennzeichnet, dass** das Gehäuse (102) mit dem Gehäusedeckel (140) verschraubt ist.

6. Kühlungsanordnung nach einem der Ansprüche 1 bis 5,
**dadurch gekennzeichnet, dass** das Deckeloberteil (141) und das Deckelunterteil (142) miteinander verschraubt, verschweißt oder verklebt sind.

7. Kühlungsanordnung nach einem der Ansprüche 1 bis 6,
**dadurch gekennzeichnet, dass** Elektronik-Baugruppen unterhalb des Gehäusedeckels (140) angeordnet sind.

8. Kühlungsanordnung nach einem der Ansprüche 1 bis 7,
**dadurch gekennzeichnet, dass** die erste Kühlstruktur (120) und die zweite Kühlstruktur (130) miteinander parallel oder in Serie verbunden sind.

## Claims

1. Cooling assembly (101) for cooling a frequency converter module (100), having a housing (102) accommodating frequency converter components, with a housing interior (106) surrounded by a housing wall (103) and with a first cooling structure (120) for cooling the liquid of a power semiconductor module (111) arranged in the housing interior (106) and with a second cooling structure (130) for cooling the liquid of a housing cover (140) of the housing (102) of the frequency converter module (100), wherein the first cooling structure and the second cooling structure are connected to one another,
**characterised in that**
- the first cooling structure (120) has an inlet (121) for supplying coolant to the power semiconductor module (111) and a cooling tub (15) below the power semiconductor module (111) as well as a return line (122) for draining the coolant from the power semiconductor module (111), and
- the second cooling structure (130) has a first bypass channel (131) arranged in the housing wall (103) for supplying coolant to the housing cover (140) and the housing cover itself as well as a second bypass channel (132) arranged in the housing wall (103) for draining coolant from the housing cover (140).

2. Cooling assembly according to claim 1,
**characterised in that** the housing cover (140) is composed of a cover upper part (141) and a cover lower part (142) and these are moulded such that the housing cover (140), when assembled, has a cooling channel within it.

3. Cooling assembly according to claim 2,
**characterised in that**
the cover upper part (141) has an upper half (144) of the cooling channel and the cover lower part (142) has a lower half (145) of the cooling channel.

4. Cooling assembly according to claim 2 or 3,
**characterised in that** the cover upper part (141) and the cover lower part (142) are die-cast parts.

5. Cooling assembly according to one of claims 1 to 4,
**characterised in that** the housing (102) is screwed to the housing cover (140).

6. Cooling assembly according to one of claims 1 to 5,
**characterised in that** the cover upper part (141) and the cover lower part (142) are screwed, welded or glued to one another.

7. Cooling assembly according to one of claims 1 to 6,
**characterised in that** electronic modules are arranged below the housing cover (140).

8. Cooling assembly according to one of claims 1 to 7,
**characterised in that** the first cooling structure (120) and the second cooling structure (130) are connected in parallel or in series with one another.

## Revendications

1. Agencement (101) de refroidissement pour le refroidissement d'un module (100) de convertisseur de courant comprenant un coffret ( 102 ) recevant des composants de redresseur de courant, dont l'intérieur ( 106 ) est entouré par une paroi ( 103 ) de coffret et ayant une première structure ( 120 ) de refroidissement pour le refroidissement par du liquide d'un module ( 111 ) de puissance à semi-conducteur disposé à l'intérieur ( 106 ) du coffret, ainsi qu'une deuxième structure ( 130 ) de refroidissement pour le refroidissement par du liquide d'un couvercle ( 140 ) du coffret ( 102 ) du module ( 100 ) du convertisseur de courant, la première structure de refroidissement et la deuxième structure de refroidissement étant en liaison entre elles,
**caractérisé**
- **en ce que** la première structure ( 120 ) de refroidissement a une entrée ( 121 ) pour l'envoi de liquide de refroidissement au module ( 111 ) à semi-conducteur de puissance et une cuvette ( 150 ) de refroidissement en dessous du module ( 111 ) à semi-conducteur de puissance, ainsi qu'un retour ( 122 ) pour évacuer du fluide de refroidissement du module ( 111 ) à semi-conducteur de puissance et
- **en ce que** la deuxième structure ( 130 ) de refroidissement a un premier canal ( 131 ) de dérivation, qui est disposé dans la paroi ( 103 ) du coffret et qui est destiné à envoyer du liquide de refroidissement au couvercle ( 140 ) du coffret, et le couvercle soi-même, ainsi qu'un deuxième canal ( 132 ) de dérivation disposé dans la paroi ( 103 ) du coffret et destiné à évacuer du liquide de refroidissement du couvercle ( 140 ) du coffret.

2. Agencement de refroidissement suivant la revendication 1,
**caractérisé en ce que** le couvercle ( 140 ) du coffret est constitué d'une partie ( 141 ) supérieure de couvercle et d'une partie ( 142 ) inférieure de couvercle et celles-ci sont conformées de manière à ce que le couvercle ( 140 ) du coffret ait, à l'état assemblé, un canal de refroidissement à l'intérieur.

3. Agencement de refroidissement suivant la revendication 2,
**caractérisé en ce que** la partie ( 141 ) supérieure du couvercle a une moitié ( 144 ) supérieure du canal de refroidissement et la partie ( 142 ) inférieure du couvercle a une moitié ( 145 ) inférieure du canal de refroidissement.

4. Agencement de refroidissement suivant la revendication 2 ou 3,
**caractérisé en ce que** la partie ( 141 ) supérieure du couvercle et la partie ( 142 ) inférieure du couvercle sont des pièces coulées sous pression.

5. Agencement de refroidissement suivant l'une des revendications 1 à 4,
**caractérisé en ce que** le coffret ( 102 ) est vissé au couvercle ( 140 ) du coffret.

6. Agencement de refroidissement suivant l'une des revendications 1 à 5,
**caractérisé en ce que** la partie ( 141 ) supérieure du couvercle et la partie ( 142 ) inférieure du couvercle sont vissées, soudées, ou collées entre elles.

7. Agencement de refroidissement suivant l'une des revendications 1 à 6,
**caractérisé en ce que** des modules d'électronique sont mis en dessous du couvercle ( 140 ) du coffret.

8. Agencement de refroidissement suivant l'une des revendications 1 à 7,
**caractérisé en ce que** la première structure ( 120 ) de refroidissement et la deuxième structure ( 130 ) de refroidissement sont reliées entre elles en parallèle ou en série.
